Europäisches Patentamt

European Patent Office

Office européen des brevets

(19)

(11) EP 0 586 889 B1

(12) EUROPÄISCHE PATENTSCHRIFT

(45) Veröffentlichungstag und Bekanntmachung des Hinweises auf die Patenterteilung:
14.10.1998 Patentblatt 1998/42

(51) Int Cl.6: **G01R 23/17**, G01R 25/00, H01Q 3/26, G01R 19/00

(21) Anmeldenummer: 93112616.3

(22) Anmeldetag: 06.08.1993

(54) **Verfahren zur Messung von Amplitude und Phase mehrerer hochfrequenter Signale**

Method for measuring the amplitude and phase of a plurality of high frequency signals

Méthode de mesure d'amplitude et de phase de plusieurs signaux haute fréquence

(84) Benannte Vertragsstaaten:
FR GB IT

(30) Priorität: 05.09.1992 DE 4229745

(43) Veröffentlichungstag der Anmeldung:
16.03.1994 Patentblatt 1994/11

(73) Patentinhaber: DORNIER GMBH
D-88004 Friedrichshafen (DE)

(72) Erfinder:
• Völker, Michael, Dipl.-Phys.
D-88677 Markdorf (DE)
• Zahn, Rolf, Dr.-Ing.
D-88677 Markdorf (DE)

(74) Vertreter: Landsmann, Ralf, Dipl.-Ing.
Dornier GmbH
LHG
88039 Friedrichshafen (DE)

(56) Entgegenhaltungen:
EP-A- 0 252 620          EP-A- 0 322 739
US-A- 4 695 790          US-A- 4 926 186

## Beschreibung

Die Erfindung betrifft ein Verfahren zur Messung von Phase und Amplitude mehrerer räumlich getrennter Wechselsignale. Unter Wechselsignalen sollen Signale verstanden werden, deren Frequenzspektrum nominell nur Anteile mit Periodendauern kleiner als die Dauer eines Meßzyklus besitzt. Als Signale kommen die physikalischen Größen in Betracht, die einen Modulator zur Veränderung (in Phase oder Amplitude) eines optischen Trägers ansteuern können, insbesondere Signale elektrischer oder optischer Natur. Angewendet werden kann solch ein Verfahren z.B. bei einer mehrelementigen Antenne, deren elektrische Signale für die Einzelstrahler in Amplitude und Phase kalibriert werden sollen, um eine vorgegebene Abstrahlcharakteristik zu realisieren.

Gegenwärtig werden Signalverteilnetzwerke mit all ihren beteiligten Baugruppen überwiegend so ausgelegt, daß alle zu erwartenden Schwankungen im Phasen- und Amplituden-Übertragungsverhalten zusammengenommen einen dem System vorgeschriebenen Gesamtfehler nicht überschreiten. Solch eine strenge Systemauslegung jedoch verbietet oft hinsichtlich anderer Kriterien (wie z. B. ihres Wirkungsgrades) optimale Bauelemente zu verwenden, da diese eine zu große Drift aufweisen würden. Eine Möglichkeit wäre, ein mehrfach ausgelegtes Regelsystem (mindestens eine Regelung pro Signal) vorzusehen. Ein solcher Aufbau wäre aber sehr komplex und fehleranfällig.

In der **US 4,926,186** ist ein Verfahren zum Vermessen von Amplitude und Phase mehrerer hochfrequenter Signale am Beispiel der elektrischen Signale zur Steuerung der Antennenelemente einer phasengesteuerten Antenne beschrieben. Dabei werden die Sendesignale der Antennenelemente auf einem einzelnen Detektor gesammelt und mittels Fourier-Transformation analysiert.

Aufgabe der Erfindung ist es, ein Verfahren anzugeben, mit der Störeinflüsse, z.B. durch die mechanische, akustische und thermische Umgebung, weitgehend unterdrückt werden können.

Diese Aufgabe wird durch das Verfahren nach Anspruch 1 gelöst. Eine Vorrichtung zur Durchführung des erfindungsgemäßen Verfahrens ist Gegenstand weiterer Ansprüche.

Die vorliegende Erfindung löst diese Aufgabe durch einen optisch/ optoelektronischen Aufbau, der geeignet ist, Phase und Amplitude einer hohen Zahl von Signalen zu vermessen. Im Gegensatz zu Lösungen nach Stand der Technik ist kein mehrfach ausgelegtes Regelsystem notwendig. Erfindungsgemäß moduliert jeweils ein zu vermessendes Signal einen Zweig eines zentral erzeugten und in die einzelnen Zweige aufgespaltenen optischen Trägersignals. Die modulierten optischen Signale der einzelnen Zweige werden anschließend zu einem Summensignal überlagert. Das Summensignal wird an einem optischen Detektor gemessen. Die optischen Weglängen für jeden Zweig, d.h. vom Ort der Aufspaltung bis zum Ort der Detektion des Summensignals am optischen Detektor werden verschieden voneinander gewählt. Das Summensignal wird hinsichtlich Amplitude und Phase der Hauptlinie und mindestens eines Seitenbands relativ zum zentral erzeugten Trägersignal vermessen. Diese Messungen werden für mehrere Frequenzen des zentral erzeugten optischen Trägersignals durchgeführt. Aus der so ermittelten Amplituden- und Phasenwerten für die Hauptlinie und mindestens eines Seitenbands bei mehreren Frequenzen des zentral erzeugten optischen Trägersignals werden Parameter werte, die die Amplituden- und Phasenwerte der den einzelnen zweigen zugeordneten hochfrequenten Signale repräsentieren, für die einzelnen Zweige separiert voneinander ermittelt, wobei die Antwort des Seitenbands eines Zweigs auf die Antwort der zugehörigen Hauptlinie normiert wird.

Als Randbedingung bei der Durchführung des Verfahrens ist zu beachten, daß die Kohärenzlänge des optischen Trägersignals verglichen mit den maximalen Weglängenunterschieden zwischen den einzelnen Zweigen ausreichend groß ist.

Eine Vermessung des Summensignals hinsichtlich Amplitude und Phase der Hauptlinie und Seitenbänder relativ zum zentral erzeugten Trägersignal ist durch verschiedene an sich bekannte homo- und heterodyne Verfahrensweisen möglich. Als Beispiel für ein Heterodyn-Verfahren kann ein zusätzlicher Zweig des optischen Trägersignals (der keiner Modulation unterzogen wird) nach Durchlaufen eines frequenzverschiebenden Elements dem Summensignal überlagert werden, um aus der optisch kohärenten Überlagerung mit dem modulierten Licht der anderen Zweige die nötige Phaseninformation zu erhalten (ähnlich holographischen Prinzipien). Die optische Weglänge des zusätzlichen Zweigs muß sich von den anderen Zweigen ausreichend unterscheiden, um von Korrelationstermen zwischen zwei beliebigen anderen Zweigen entkoppelt zu bleiben. Dies kann durch Verringerung des Frequenz-Abstands des optischen Trägersignals einer Meßsequenz erreicht werden.

Eine Vorrichtung zur Durchführung des erfindungsgemäßen Verfahrens umfaßt:

- eine in ihrer Frequenz regelbare Lichtquelle zur Erzeugung des optischen Trägersignals
- Mittel zur Aufteilung des optischen Trägersignals in einzelne Zweige
- Modulatoren, mit denen jeweils ein Zweig des zentralen optischen Trägersignals von einem der zu vermessenden Signale moduliert wird
- Mittel zur Überlagerung der modulierten optischen Signale der einzelnen Zweige zu einem Summensignal
- einen optischen Detektor zur Messung des Summensignals
- wobei die optische Weglängen von der Aufteilung bis zur Überlagerung für jeden einzelnen Zweig verschieden sind.

Die räumliche Anordnung der einzelnen Zweige des optischen Trägersignals zusammen mit den Mitteln zur Aufteilung und Überlagerung sowie der Modulatoren wird im folgenden auch als Netzwerk bezeichnet.

Die optischen Signale werden vorteilhaft in Glasfasern geführt, wobei die Aufteilung und Überlagerung einzelner Zweige durch optische Koppler geschieht. Jedoch können die optischen Signale anstatt in Glasfasem auch mit Hilfe von freiraumoptischen Elementen geführt werden. Zur Aufteilung und Überlagerung der einzelnen optischen Zweige werden dann z.B. halbdurchlässige Spiegel oder Gitter verwendet.

Für die einzelnen optischen Elemente können neben Transmissionselementen auch Reflexionselemente, die z. B. wieder Transmissionselemente enthalten können, verwendet werden, so daß das optische Signal dieselbe Strecke hin- und zurückläuft.

Als Modulatoren sind zum Beispiel elektrooptische Amplituden- oder Phasenmodulatoren oder akustooptische Bauelemente geeignet. Lediglich in der Phasenbeziehungen der erzeugten optischen Seitenbänder zur Hauptlinie unterscheiden sie sich, was für die Auswertung im allgemeinen keinen wesentlichen Unterschied bedeutet. Nichtlinearitäten der Wandler werden vermieden, indem das System nur für niedrige Modulationstiefen ausgelegt wird. Ansonsten ist eine nachträgliche Korrektur bei bekanntem Übertragungsverhalten oft noch möglich (evt. unter zusätzlicher Berücksichtigung von mehreren Seitenbändern höherer Ordnung).

Vorteilhaft können Modulatoren verwendet werden, die, abhängig von der Ausbreitungsrichtung des modulierenden Signals relativ zu der des zu modulierten optischen Signals, unterschiedlich effizient in ihrer Modulation sind. Damit kann dasselbe optische Netzwerk in beiden Richtungen betrieben werden, um beispielsweise Stehwellenwerte messen zu können.

Im Falle von zu messenden elektrischen Signalen kann ein Modulator auch in der Weise aufgebaut sein, daß ein elektrooptisches Modulationselement im elektrischen Feld nahe einer Leitung, die das elektrische Signal führt, angeordnet wird, z.B. kann das elektrooptische Element in der ohnehin vorhandenen dielektrischen Isolatorschicht der elektrischen Leitung angeordnet sein.

Die optischen Weglängen der einzelnen Zweige dürfen sich während eines kompletten Meßzyklus relativ zueinander nur gering verändem. Insbesondere äußere Störungen wie Temperaturschwankungen (absolut oder im Gradient über den Ort) oder akustische Wellen (Körperschall oder über sonstige Medien) beeinflussen die optische Länge der Teilstrecken der Netzwerke. Absolute Änderungen der optischen Länge in der Größenordnung der Wellenlänge des Lichtes während eines Meßzyklus können sich bereits drastisch auf die Meßgenauigkeit auswirken. Vermeiden läßt sich das, indem alle Glasfaserstrecken, in denen Licht geführt wird, welches kohärent überlagert werden soll, eng nebeneinander geführt werden. Im einfachsten Fall bedeutet das, daß entlang eines gemeinsamen Weges pro Weglängenelement für jede am Bündel beteiligte Glasfaser das gleiche Längenelement beteiligt ist. Verschiedene Verseiltechniken sind vorteilhaft anwendbar, auch die Verdrillung der Fasern untereinander kann angewendet werden. Durch den engen Kontakt wirken äußere Störungen, wie z. B. Temperaturänderungen, in guter Näherung homogen über den gesamten Querschnitt des Faserbündels (die Glasfasern geben im Betrieb nur vernachlässigbar viel Wärme ab, so daß dadurch kaum zusätzliche Thermalgradienten entstehen) wirken. Damit ändert sich die optische Länge in allen beteiligten Glasfasern in gleichem Maße und wirkt sich bei der optischen Überlagerung nicht mehr aus, da nur die Phasenunterschiede zwischen den Kanälen das Messergebnis beeinflussen. Bei Homodyn- oder Heterodyn-Empfangstechniken empfiehlt es sich daher, auch das Licht eines Lokaloszillators oder sonstiges Referenzlicht über eine Glasfaser entlang des übrigen Meßnetzwerkes zu legen um darin die gleichen Phasenvariationen aufgrund äußerer Störungen zu erhalten. Die zur Erreichung unterschiedlich langer optischer Weglängen der einzelnen Zweige notwendigen Verzögerungselemente können in einem separat gekapselten Teil der Vorrichtung angeordnet werden.

Zur Regelung und Einstellung der verschiedenen optischen Trägerfrequenzen innerhalb eines Meßzyklus kann vorteilhaft ein Interferometer (z.B. Michelsson-, Mach-Zehnder- oder Ring-Interferometer) mit unterschiedlich langen Zweigen zur Erzeugung eines Kontrollsignals verwendet werden. Die verzögerungsbestimmenden Elemente der einzelnen Interferometerzweige können ebenfalls in dem weiter oben erwähnten separat gekapselten Teil der Vorrichtung angeordnet werden, so daß gemeinsame gleiche Phasenlaufzeitänderungen jedes darin enthaltenen Streckenelementes (beispielsweise durch gemeinsame Temperaturänderungen) keine Auswirkungen auf das gewünschte Phasenverhalten des Aufbaus haben.

In einer vorteilhaften Ausführung ist der gesamte optische Aufbau der Vorrichtung polarisationserhaltend aufgebaut. Möglich ist aber auch, den optischen Aufbau nicht in allen seinen Komponenten polarisationserhaltend aufzubauen. Verbleibende Unsicherheiten in den Polarisationszuständen beim Überlagern der beteiligten Zweige werden vorteilhaft ausgeschaltet durch Messung des Polarisations-Übertragungsverhaltens durch Überlagerung im Empfang mit Hilfe mindestens zweier voneinander unabhängiger Polarisationzustände.

Für die Lichtquelle können vorteilhaft in ihrer Frequenz durchstimmbare Laser verwendet werden. Andererseits ist auch die Verwendung von in ihrer Frequenz stabilen Lichtquellen möglich, wobei deren Licht dann zusätzlich frequenzmoduliert wird, um die notwendigen verschiedenen Frequenzen innerhalb eines Meßzyklus zu erhalten.

Die Länge der Netzwerkteile vom Modulator bis zum optische Empfänger muß ausreichend genau bekannt sein, um mit Hilfe der berechneten Laufzeiten der Signale auf ihre tatsächliche Phase relativ untereinander zurückschließen zu können (ohne Beschränkung der Allgemeinheit mögen sich zur Betrachtung der Gleichzeitigkeit das Netzwerk und der Beobachter in demselben Inertialsystem befinden). Beispielsweise gibt es bei satellitengestützten X-Band-Antennen mit mehreren Meter langen Glasfaserstrecken aufgrund der extremen thermischen Umgebung unakzeptable Phasenungenauigkeiten für das Signal. Bekannt sind bisher nur einkanalige Verfahren zur Bestimmung der Laufzeit eines optischen Signals in einem Glasfaserstück z.B. in Giles et.al.: Coherent optical fibre sensors with modulated laser sources; Electronic Letters 6. Januar 1983, Vol. 19 No. 1. Es ist deshalb eine weitere vorteilhafte Anwendung des erfindungsgemäßen Verfahren, daß mit ihm die optische Länge sämtlicher Zweige bestimmt werden kann (mehrkanaliges Verfahren), wobei ein ausreichend großes optisches Frequenzintervall überdeckt werden muß. Dabei können Transmissions oder Reflexionsmessungen verwendet werden. Beispielsweise kann der Ort gezielt angefügter oder ohnehin immer vorhandener Reflexionen an Materialübergängen des Modulators vermessen werden. Transmissionsmessungen genügen, sofern aus der Gesamtlänge auf die Länge vom Modulator zum Detektor ausreichend genau geschlossen werden kann (z.B. durch bekannt feste Teilverhältnisse im Weg zum und vom Modulator).

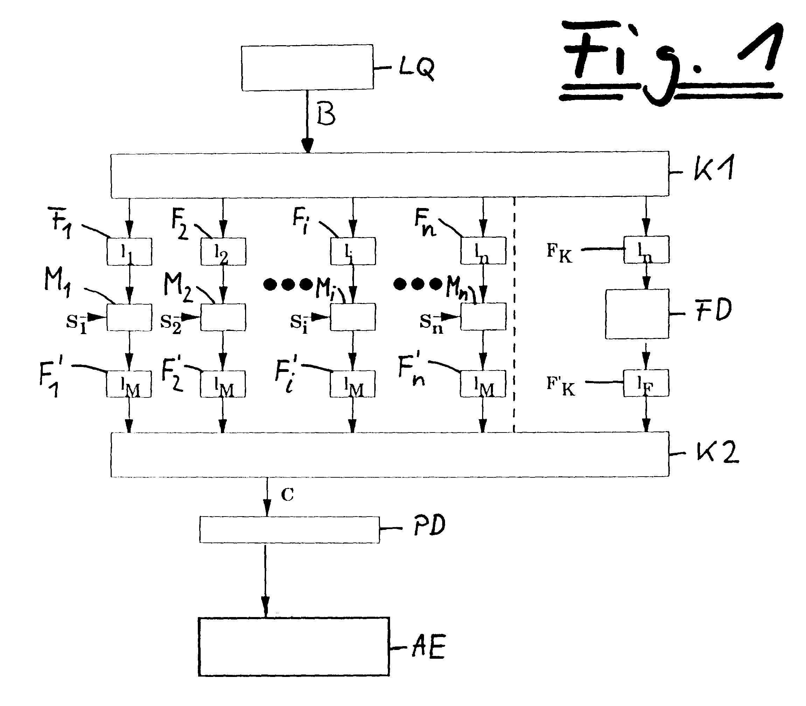

Die Erfindung wird nun anhand der Fig. 1 bis 3 eingehend beschrieben. Sie zeigen jeweils Vorrichtungen zur Durchführung des erfindungsgemäßen Verfahrens.

Fig. 1 zeigt eine Vorrichtung zur Durchführung des erfindungsgemäßen Verfahren. Es liegen n räumlich getrennte Signale $S_i$ mit i= 1 bis n der Frequenz f vor. Diese könnten z.B. elektrische Signale im Signalverteilnetzwerk einer Gruppenantenne sein. Dabei wird ein zentral erzeugtes elektrisches Signal S fester Frequenz f in n elektrische Signale $S_i$ mit i= 1 bis n zur Ansteuerung der einzelnen Antennenelemente aufgeteilt.

Das erfindungsgemäße Verfahren wird angewendet, um diese Vorrichtung zu kalibrieren, d.h. die n elektrischen Signale $S_i$ in Amplitude und Phase zu bestimmen. Dazu wird das Gleichlichtsignal B eines zentralen - in seiner Frequenz v regelbaren - schmalbandigen Lasers LQ in einem passiven Koppler K1, z.B. einem Sternkoppler, in n Glasfasern $F_i$ mit i=1 bis n (n Zweige) der optischen Länge $l_i$ sowie in eine Kontrollfaser FK aufgeteilt. Jedem Zweig ist ein zu messendes Signal $S_i$ zugeordnet. Die n Glasfasern werden jeweils zu einem Modulator $M_i$ geführt. Diese werden von den zu messenden Signalen $S_i$ (die sich nur in der zu messenden Phase und Amplitude vom zentral erzeugten Signal S unterscheiden) angesteuert. Der Lichtweg (effektiver Brechungsindex mal Faserlänge/Lichtgeschwindigkeit) $l_i$ bis zum optischen Modulator $M_i$ betrage i ns (1ns entspricht etwa 20 cm Faser) für Zweig i (i = 1, ..., n). Wo die Strecke $l_i$ beginnt ist gleichgültig, solange ein gemeinsamer Startpunkt für alle Zweige (inklusive Hilfszweige) verwendet wird. Der gemeinsame Startpunkt liege zum Beispiel im Sternkoppler K1.

An den Modulatoren $M_i$ entsteht aus dem schmalbandigen Licht am Eingang von $M_i$ ein optisches Signal mit Hauptlinie und Seitenbändern am Ausgang. Bei Amplituden- oder Phasenmodulatoren entstehen die Seitenbänder $B_{i+}$ und $B_{i-}$ bei den Frequenzen v + f und v - f. Seitenbänder höherer Ordnung werden hier nicht betrachtet. Phase und Amplitude der optischen Seitenbänder stehen in bekannter Beziehung zur Hauptlinie und elektrischem Eingangssignal. Sie sind von der Effizienz und dem Typ des Modulators abhängig. Für dieses Beispiel wird die Antwort des Ausgangssignals als näherungsweise linear abhängig von optischem und elektrischem Eingang angenommen. Über Glasfasern $F'_i$ der optischen Länge $l_M$ (konstant, z. B. 1 ns) werden alle Modulatorausgänge auf einen gemeinsamen Überlagerungskoppler K2 geführt. Dort werden die optischen Signale der einzelnen Zweige zu einem optischen Summensignal C kohärent überlagert.

In dem hier angegebenen Beispiel sind somit die optischen Weglängen zwischen Koppler K1, an dem die Aufteilung in einzelne Zweige vorgenommen wird, und den Modulatoren $M_i$ unterschiedlich gewählt, während die optischen Weglängen zwischen den Modulatoren $M_i$ und dem Überlagerungskoppler K2 für alle Zweige gleich sind. Von Bedeutung ist aber letztendlich die Gesamtlänge vom Koppler K1 bis zum Überlagerungskoppler K2. Die notwendigen Längendifferenzen können also sowohl vor als auch nach den Modulatoren $M_i$ vorhanden sein. Im Photodetektor PD am Ausgang des Kopplers K2 wird die Lichtleistung in einen elektrischen Strom umgesetzt. Dieser wird mit bekannten elektrischen Auswerteschaltungen innerhalb der Auswerteelektronik AE analysiert.

In den folgenden Formeln werden die bisher erwähnten Zusammenhänge beschrieben. Zur Vereinfachung der mathematischen Beschreibung werden verlustfreie polarisationserhaltende Bauelemente angenommen. Optische wie elektrische Signale werden durch komplexe Größen dargestellt. Im optischen Fall sei der Realteil dieser Größe proportional zu einer elektrischen Feldstärke (z. B. im Zentrum einer einmodigen Glasfaser). Im elektrischen Fall entspricht der Realteil der anliegenden Spannung. Die angesprochenen Algorithmen können in der Praxis durch geeignete Filterungen verfeinert werden. Die angegebenen Größen entsprechen den im Labormaßstab mit diodengepumpten Nd: YAG Ringlasern realisierbaren Möglichkeiten. Frequenzaddition, -Subtraktion und Filterung werden im elektrischen wie im optischen Bereich durch bekannte Mischer, Filter bzw. akustooptische Komponenten durchgeführt.

Zu bestimmen ist das Verhältnis der elektrischen Signale $S_i$ zum zentral erzeugten Signal S. Es wird durch den komplexen Koeffizienten $y_i$ beschrieben (j = imaginäre Einheit):

$$S(t) = e^{2\pi jft} \tag{1}$$

$$S_i(t) = y_i S(t). \tag{2}$$

Optisch gespeist werden die Zweige der einzelnen Glasfasern $F_i$ bzw. $F'_i$ vom Laser LQ mit dem Signal:

$$B(t) = e^{2\pi j v t}. \tag{3}$$

Zur Vereinfachung wird hier angenommen, daß das Signal B(t) am Koppler K1 ausgeht. Nach Phasenverschiebungen und dem Abschwächen (komplexer Faktor $x_i$) und der Verzögerung $l_i$ liegt am Eingang des Modulators $M_i$ jeweils das Signal

$$B_i(t) = x_i B(t-l_i) = x_i B(t) e^{-2\pi j v l_i}. \tag{4}$$

Für jeden Modulator gleich sei die Effizienz p, mit der durch das elektrische Signal das optische moduliert wird. Für die Seitenbänder $B_{i+}$ und $B_{i-}$ gilt dann am Ausgang des Modulators $M_i$ ("*" bedeutet komplex konjugieren):

$$B_{i+}(t) = pS_i(t)B_i(t) = pS(t)B(t) y_i x_i e^{-2\pi j v l_i} \tag{5}$$

$$B_{i-}(t) = [pS_i(t)]^* B_i(t) = p^* S^*(t) B(t) y_i^* x_i e^{-2\pi j v l_i}. \tag{6}$$

Im folgenden werden sämtliche Ausdrücke im Zusammenhang mit der Hauptlinie mit einem tiefgestellten $*$ versehen, Terme im Zusammenhang mit den Seitenbändern mit tiefgestelltem + oder -.
In erster Näherung bleibt die Hauptlinie - abgesehen von einem bekannten Dämpfungsfaktor q - beim Durchgang durch den Modulator unverändert. Zu den Seitenbändern hinzu kommt damit noch am Ausgang von $M_i$ das Signal:

$$B_{i*}(t) = qB_i(t) = qB(t) x_i e^{-2\pi j v l_i}. \tag{7}$$

Über Glasfasern $F'_i$ der optischen Länge $l_M$ (konstant, z. B. 1 ns) werden alle Modulatorausgänge auf den gemeinsamen Überlagerungskoppler K2 z.B. einen Sternkoppler geführt.

In einem Kontrollzweig wird aus dem Eingangsverzweiger K1 über die Glasfaser $F_K$ ein frequenzverschiebendes Bauelement FD (z. B. ein akustooptischer Ablenker) gespeist und das Signal dort um vorteilhaft einen Bruchteil der elektrischen Frequenz f des Signals S(t) nach unten frequenzverschoben. Das z.B. um f/3 nach unten verschobene optische Linie des Kontrollzweigs wird über die Faser $F'_K$ ebenfalls in den Überlagerungskoppler K2 geführt. Der optische Weg für diesen Kontrollzweig (gemessen von K1 bis K2) betrage beispielsweise $l_F = l_M$ (diese Länge eignet sich, um die folgende mathematische Beschreibung zu vereinfachen). Dieses Beispiel eines einfachen Heterodynverfahrens zur Amplituden- und Phasendetektion mit Hilfe des Signals $C_F$ wird hier vor allem aufgrund seiner einfachen mathematischen Beschreibung angeführt. Dem Fachmann stehen jedoch auch andere bekannte Verfahren - auch ohne im Verzweiger K1 abgezweigte Kontrollzweige zur Verfügung.

Im Überlagerungskoppler K2 werden alle Signale in ihrer Feldstärke zum optischen Summensignal C(t) addiert:

$$C(t) = C_F (t-l_F) + \Sigma_i C_i(t-l_M) \tag{8}$$

mit:

$$C_F(t-l_F) = B(t-l_F) x_F e^{-2\pi j f/3 t}$$

und

$$C_i(t-l_M) = B_{i-}(t-l_M) + B_{i+}(t-l_M) + B_{i*}(t-l_M).$$

Im Photodetektor PD am Ausgang des Kopplers K2 wird die Lichtleistung in einen elektrischen Strom umgesetzt. Bei einem Konversionsfaktor r beträgt der elektrische Strom am Ausgang des Photodetektors (er sei in infinitesimalem Abstand zum Ausgangskoppler K2 angebracht):

$$I(t) = rC(t)C^*(t)$$

$$= r(D_0 + D_{f/3}(t) + D_{f\,2/3}(t) + D_f(t) + D_{f\,4/3}(t) + D_{2f}(t)). \tag{9}$$

Die Terme $D_0$, $D_{f/3}$, ... stehen für die verschiedenen Signalfrequenzanteile, die durch die Mischterme entstehen:

$D_0$      Summe aller Terme mit $B_{i-} B_{k-}{}^*$, $B_{i+} B_{k+}{}^*$, $B_{i*} B_{k*}{}^*$ und $C_F C_F{}^*$
$D_{f/3}$      Summe aller Terme mit $B_{i*} C_F{}^*$ und $C_F B_{k*}{}^*$
$D_{f\,2/3}$      Summe aller Terme mit $B_{i-} C_F{}^*$ und $C_F B_{k-}{}^*$
$D_f$      Summe aller Terme mit $B_{i-} B_{k*}{}^*$, $B_{i*} B_{k-}{}^*$, $B_{i+} B_{k*}{}^*$ und $B_{i*} B_{k+}{}^*$
$D_{f\,4/3}$      Summe aller Terme mit $B_{i+} C_F{}^*$ und $C_F B_{k+}{}^*$
$D_{2f}$      Summe aller Terme mit $B_{i-} B_{k+}{}^*$ und $B_{i+} B_{k-}{}^*$

Die Summanden der Terme $D_{f/3}$ und $D_{f\,4/3}$ sind linear in der Antwort $B_{i*}$ bzw. der Antwort $B_{i+}$. Für die weitere Auswertung genügt es, Amplitude und Phase dieser beiden Terme zu betrachten. Damit kann auf Amplitude und Phase des Trägersignals und des oberen Seitenbandes geschlossen werden. Die übrigem Terme werden nicht benötigt (der Term $D_{f\,2/3}$ z.B. liefert zusätzliche Informationen über das untere Seitenband, was zur Verbesserung der Meßgenauigkeit verwendet werden kann) oder stören aufgrund ihrer quadratischen Angängigkeit von $B_{i-}$, $B_{i*}$ oder $B_{i+}$. Diese störenden Terme werden in dem hier beschriebenen Heterodynverfahren ausgeblendet, z.B. durch Bandfilter in elektrischen Schaltungen. Ein anderes Verfahren ohne f/3 -Frequenzverschiebung des Kontrollzweiges bestünde z.B. in einer deutlich von der optischen Weglänge $l_i + l_M$ der einzelnen Zweige verschiedenen Verzögerungslänge $l_F$ (z.B. bei den oben angegebenen Werte für $l_i + l_M$: $l_F = 2^*n$ ns). Damit würden jedoch Nutz- von Störsignalen erst in weiteren Verarbeitungsschritten getrennt werden können.

$D_{f/3}(n)$ und $D_{f\,4/3}(n)$ bestehen aus:

$$D_{f/3}(t) = E_{f/3}(t) + E_{f/3}{}^*(t) \tag{10}$$

mit:

$$E_{f/3}(t) = C_F(t)\Sigma_i B_{i*}{}^*(t-l_M)$$

$$(7,8) = B(t-l_F)\, x_F\, e^{-2\pi jf/3t}\Sigma_i\, q^*\, B^*(t-l_M)\, x_i{}^*\, e^{+2\pi j\nu l_i},$$

proportional zum Integral von 0 bis 3/f über $I(t-\tau)e^{2\pi j\tau f/3}d\tau$, wobei I der Strom am Ausgang des Photodetektors ist. Die vom Index i unabhängigen Terme können aus der Summe herausgezogen werden, somit gilt:

$$E_{f/3}(t) = B(t-l_F)\, q^*\, B^*(t-l_M)\, x_F\, e^{-2\pi jf/3t}\Sigma_i\, x_i{}^*\, e^{+2\pi j\nu l_i}$$

$$(3) = q^*\, e^{2\pi j\nu(t-l_F)-2\pi j\nu(t-l_M)} x_F e^{-2\pi jf/3t}\, \Sigma_i x_i{}^*\, e^{2\pi j\nu l_i}$$

$$(l_F = l_M) = e^{-2\pi jf/3t}\Sigma_i\, q^*\, z_i\, e^{2\pi j\nu l_i} \tag{11}$$

mit:

$$z_i = x_F x_i{}^*$$

Ebenso gilt:

$$D_{f\,4/3}(t) = E_{f\,4/3}(t) + E_{f\,4/3}{}^*(t) \tag{12}$$

mit:

$$E_{f\,4/3}(t) = C_F(t)\Sigma_i\, B_{i+}{}^*(t\text{-}l_M)$$

$$= e^{-2\pi jf4/3t}\, \Sigma_i\, p^*\, y_i{}^*z_i\, e^{2\pi jv l_i},$$

proportional zum Integral von 0 bis 3/f über $I(t\text{-}\tau)\, e^{2\pi j\tau f\,4/3}\, d\tau$.

Zur weiteren Auswertung werden folgende $v$-abhängige Größen bei allen $v$ aus $\{v_0 + k\Delta v | \Delta v = 1\ \text{GHz}/\ n;\ k = 0, 1, \dots, n\text{-}1\}$ gemessen:

$$F^*(n) = e^{2\pi jf/3t} E_{f/3}(t)/q^*$$

$$= \Sigma_i z_i\, e^{2\pi jv l_i} \tag{13}$$

$$F_+(n) = e^{2\pi jf\,4/3t} E_{f\,4/3}(t)/p^*$$

$$= \Sigma_i y_i{}^*\, z_i\, e^{2\pi jv l_i} \tag{14}$$

Die komplexen Koeffizienten $F_*(n)$ und $F_+(n)$ werden auf elektrischem Weg bestimmt (heruntermischen um f/3 bzw. f 4/3). Die Koeffizienten p und q sind bekannt (sie können z.B. durch einmalige Kalibration ermittelt werden). Aus der so ermittelten Frequenzantwort für die Hauptlinie und ein Seitenband werden anschließend die einzelnen Fourier-koeffizienten $z_i$ und $y_i{}^*\, z_i$ durch Fourier-Rücktransformation einer Meßsequenz $\{(F_*(v_0 + k\Delta v), F_+(v_0 + k\Delta v)) | \Delta v = 1\ \text{GHz}/\ n; k = 0, 1, \dots, n\text{-}1\}$ auf die Sequenz $\{(z_i, y_i{}^*\, z_i)\, l_i = 1, 2, \dots, n\}$ bestimmt.

Damit lassen sich alle gesuchten Koeffizienten $y_i$ bestimmen zu:

$$y_i = ((y_i{}^*\, z_i)/z_i)^*. \tag{15}$$

Für jeden Zweig wird somit die Antwort des Seitenbands ($y_i{}^*\, z_i$) eines Zweigs i auf die Antwort ($z_i$) ) der zugehörigen Hauptlinie normiert. Der Nenner ändert sich im Absolutbetrag nur gering. Er besteht aus dem Produkt verschiedener Durchgangsdämpfungen des Systems und wird daher im Normalbetrieb von Null verschieden bleiben.

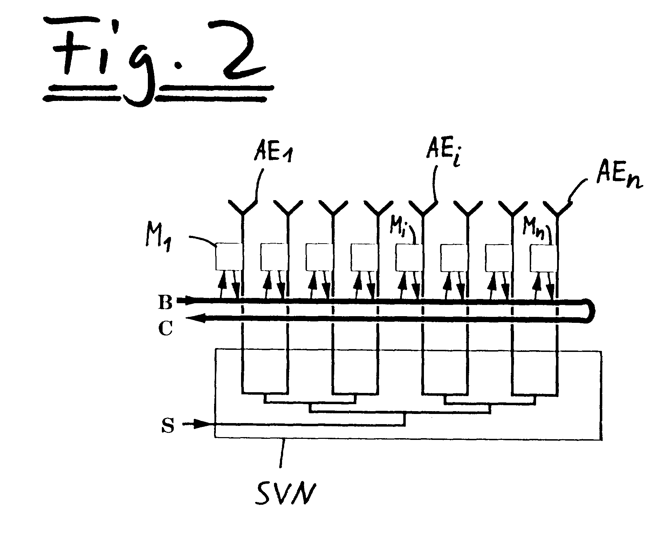

Fig. 2 zeigt in einer mehr formalen Weise einen Aufbau, mit dem das erfindungsgemäße Verfahren für den schon erwähnten Anwendungsgsfall der Kalibrierung eines Signalverteilernetzwerk SVN einer Gruppenantenne angewendet werden kann. Das zentral erzeugtes elektrisches Signal S wird zur Ansteuerung der einzelnen Antennenelemente $AE_i$ in einzelne elektrische Signale aufgeteilt. Sie bilden ein z.B. passives Signalverteilernetzwerk, daß durch Anwendung des erfindungsgemäßen Verfahrens kalibriert werden soll. Licht eines zentral erzeugten optischen Signals B wird in einzelne Zweige aufgeteilt und in Lichtleitfasern zu je einem optischen Modulator $M_i$ geführt. Sie bilden ein optischen Netzwerk zur Kalibrierung. Die optischen Signale werden in den Modulatoren $M_i$ von den zu messenden elektrischen Signalen moduliert. Die modulierten Signale werden zu einem Summensignal C aller Zweige zusammengefaßt und anschließend zu einem Detektor geführt.

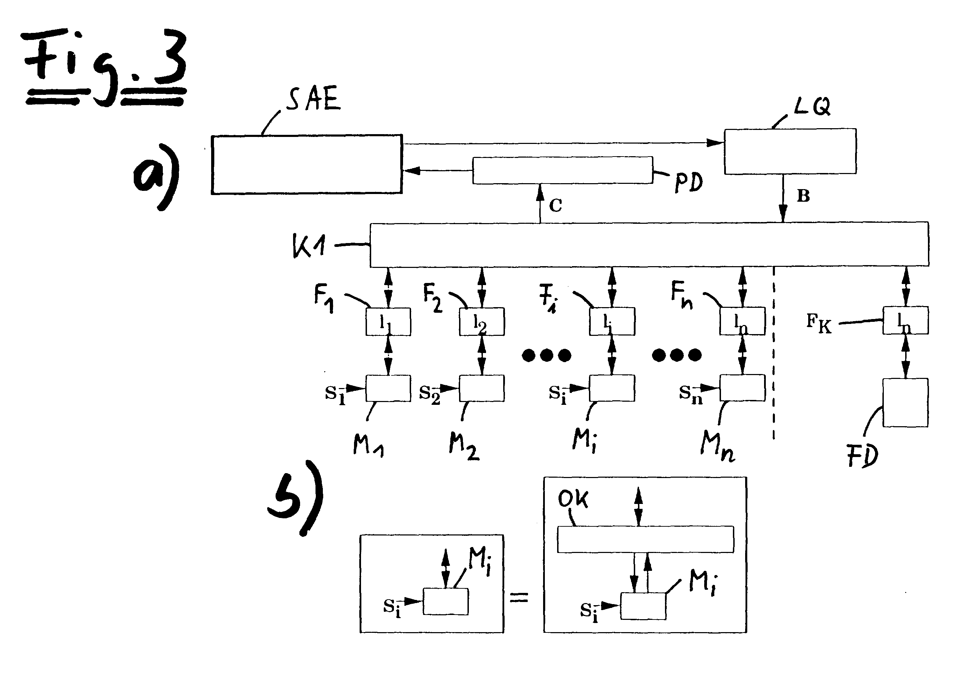

Fig. 3a zeigt eine mögliche Ausbildung der erfindungsgemäßen Vorrichtung, bei dem die Modulatoren $M_i$ als optische Reflexionselemente realisiert sind. Das optische Trägersignal B der abstimmbaren Lichtquelle LQ wird über den passiven Sternkoppler K1 auf einzelne Glasfasern $F_i$ der Länge $l_i$ verteilt und zu den Modulatoren $M_i$ geführt. Die modulierten Signale an den Ausgängen der Modulatoren $M_i$ laufen über die Glasfasern $F_i$ zurück zum Sternkoppler K1 und werden dort zum Signal C überlagert, welches an den Photodetektor PD geführt wird. Die Steuer- und Auswerteelektronik ist mit SAE bezeichnet. In Fig. 3b ist eine Ausbildung eines solchen reflektierenden Modulators dargestellt. Er entsteht aus dem Zusammenschalten eines optischen Kopplers OK (1 × 2 - Verzweiger) und einem gewöhnlichen Modulator $M_i$ mit getrenntem optischen Ein- und Ausgang. Das von der Lichtquelle LQ kommende Licht wird in dem 1 × 2 - Verzweiger OK aufgeteilt, wobei ein Teil in den Eingang des Modulators $M_i$ eingekoppelt wird. Das

Licht aus dem Ausgang des Modulators wird über den 1 × 2 - Verzweiger OK wieder in die Eingangsfaser geleitet. Der 1 × 2 - Verzweiger OK wird somit in der Rückwärtsrichtung als "Überlagerer" verwendet.

**Patentansprüche**

1. Verfahren zum Vermessen der Amplitude und Phase mehrerer hochfrequenter Signale ($S_i$), dadurch gekennzeichnet, daß jeweils ein zu vermessendes hochfrequentes Signal ($S_i$) einen Zweig eines zentral erzeugten optischen Trägersignals (B) moduliert und die modulierten optischen Signale der einzelnen Zweige anschließend zu einem Summensignal (C) überlagert werden, wobei

   - die optischen Weglängen für jeden Zweig verschieden gewählt werden und
   - für mehrere Frequenzen des zentral erzeugten optischen Trägersignals das Summensignal (C) hinsichtlich Amplitude und Phase der Hauptlinie und mindestens eines Seitenbands relativ zum zentral erzeugten Trägersignal (B) vermessen wird, und
   - aus den so ermittelten Amplituden und Phasenwerten für die Hauptlinie und mindestens eines Seitenbands bei mehreren Frequenzen des zentral erzeugten optischen Trägersignals (B) Parameterwerte, die die Amplituden- und Phasenwerte der den einzelnen Zweigen zugeordneten hochfrequenten Signale repräsentieren, für die einzelnen Zweige separiert voneinander ermittelt werden, wobei die Parameterwerte des Seitenbands eines Zweigs auf die Parameter der zugehörigen Hauptlinie normiert werden.

2. Verfahren nach Anspruch 1, dadurch gekennzeichnet, daß dem Summensignal (C) ein zusätzlicher frequenzverschobener Zweig des optischen Trägersignals (B) überlagert wird.

3. Verfahren nach Anspruch 1 oder 2, dadurch gekennzeichnet, daß die hochfrequenten Signale elektrischer Natur sind.

4. Vorrichtung zur Durchführung des Verfahrens nach einem der vorangehenden Ansprüche, mit

   - einer in ihrer Frequenz regelbaren Lichtquelle (LQ) zur Erzeugung des optischen Trägersignals (B),
   - Mittel zur Aufteilung des optischen Trägersignals (B) in einzelne Zweige,
   - Modulatoren ($M_i$), mit denen jeweils ein Zweig des zentralen optischen Trägersignals (B) von einem der zu vermessenden Signale ($S_i$) moduliert wird,
   - Mittel zur Überlagerung der modulierten optischen Signale der einzelnen Zweige zu einem Summensignal (C), und
   - einem optischen Detektor (PD) zur Messung des Summensignals (C)
   - wobei die optische Weglängen von der Aufteilung bis zur Überlagerung für jeden Zweig verschieden sind.

5. Vorrichtung nach Anspruch 4, dadurch gekennzeichnet, daß die optischen Signale der einzelnen Zweige in Glasfasern ($F_i$, $F_i'$) geführt sind.

6. Vorrichtung nach Anspruch 5, dadurch gekennzeichnet, daß die Glasfasern ($F_i$, $F_i'$) überwiegend entlang eines gemeinsamen Weges eng beieinander geführt werden.

7. Vorrichtung nach einem der Ansprüche 4 bis 6, dadurch gekennzeichnet, daß die einzelnen Zweige zur Erreichung der unterschiedlichen optischen Weglängen jeweils unterschiedlich lange Verzögerungselemente enthalten.

8. Vorrichtung nach Anspruch 7, dadurch gekennzeichnet, daß die Verzögerungselemente der einzelnen Zweige in einem separat gekapselten Teil der Vorrichtung angeordnet sind.

9. Vorrichtung nach Anspruch 8, dadurch gekennzeichnet, daß zur Regelung der Frequenz des optischen Trägersignals (B) ein Interferometer zur Erzeugung eines Kontrollsignals vorhanden ist, wobei die Verzögerungselemente der einzelnen Interferometerzweige in dem separat gekapselten Teil der Vorrichtung angeordnet sind.

10. Vorrichtung nach einem der Ansprüche 4 bis 9, dadurch gekennzeichnet, daß die Mittel zur Aufteilung und Überlagerung (K1,K2) des optischen Trägersignals (B) und/oder die Modulatoren ($M_i$) entweder optische Transmissionselemente oder optische Reflexionselemente sind.

**11.** Vorrichtung nach einem der Ansprüche 4 bis 10, dadurch gekennzeichnet, daß die optischen Signale der einzelnen Zweige in einem optischen Freiraumaufbau geführt sind.

**12.** Vorrichtung nach einem der Ansprüche 4 bis 11, dadurch gekennzeichnet, daß die Vorrichtung polarisationserhaltend aufgebaut ist.

**13.** Vorrichtung nach einem der Ansprüche 4 bis 11, dadurch gekennzeichnet, daß die Vorrichtung nicht in allen Komponenten polarisationserhaltend aufgebaut ist und verbleibende Unsicherheiten in den Polarisationzuständen beim Überlagern der einzelnen Zweige ausgeschaltet werden durch Messung des Polarisations-Übertragungsverhaltens durch Überlagerung im Empfang mit Hilfe mindestens zweier voneinander unabhängiger Polarisationszustände.

**14.** Vorrichtung nach einem der Ansprüche 4 bis 13, dadurch gekennzeichnet, daß ein Modulator ($M_i$) im Falle eines zu messenden elektrischen Signals ($S_i$) auf folgende Weise aufgebaut ist: Ein elektrooptisches Element ist in dem elektrischen Feld nahe einer Leitung, die das zu messende elektrische Signal ($S_i$) führt, angeordnet.

**15.** Vorrichtung nach einem der Ansprüche 4 bis 14, dadurch gekennzeichnet, daß Modulatoren ($M_i$) verwendet werden, die, abhängig von der Ausbreitungsrichtung des modulierenden Signals relativ zu der des zu modulierenden optischen Signals, unterschiedlich effizient in ihrer Modulation sind.

**16.** Vorrichtung nach einem der Ansprüche 4 bis 15, dadurch gekennzeichnet, daß als Lichtquelle (LQ) in ihrer Frequenz durchstimmbare Laser verwendet werden.

**17.** Vorrichtung nach einem der Ansprüche 4 bis 15, dadurch gekennzeichnet, daß in ihrer Frequenz stabile Lichtquellen (LQ) verwendet werden, wobei ein daraus abgeleitetes moduliertes Licht als optisches Trägersignal (B) verwendet wird.

**18.** Vorrichtung nach einem der Ansprüche 4 bis 17, dadurch gekennzeichnet, daß mehrere Lichtquellen und/oder optische Detektoren verwendet werden, so daß mehrere Messungen zeitlich parallel durchgeführt werden können.

**19.** Anwendung des Verfahrens nach einem der Ansprüche 1 bis 3 in einer Vorrichtung nach einem der Ansprüche 4 bis 18 zur Laufzeitmessung des optischen Trägersignals (B) in den einzelnen Zweigen.

## Claims

**1.** Method of measuring the amplitude and phase of several high-frequency signals ($S_i$), characterised in that a high-frequency signal ($S_i$) to be measured modulates a respective branch of a centrally generated optical carrier signal (B), and the modulated optical signals of the individual branches are subsequently superimposed to form a composite signal (C), wherein

- the optical path lengths for each branch are selected to be different, and
- for a plurality of frequencies of the centrally generated optical carrier signal the composite signal (C) is measured in respect of amplitude and phase of the main component and of at least one sideband relative to the centrally generated carrier signal (B), and
- from the resultant amplitudes and phase values for the main component and at least one sideband at a plurality of frequencies of the centrally generated optical carrier signal (B), parameter values that represent the amplitude values and phase values of the high-frequency signals associated with the individual branches are determined separately from one another for the individual branches, the parameter values of the sideband of a branch being normalised to the parameters of the associated main component.

**2.** Method according to claim 1, characterised in that an additional frequency-shifted branch of the optical carrier signal (B) is superimposed on the composite signal (C).

**3.** Method according to claim 1 or 2, characterised in that the high-frequency signals are electrical.

**4.** Apparatus for implementing the method according to any one of the preceding claims, having

- a light source (LQ) for generating the optical carrier signal (B),the frequency of the light source being controllable,
- means for splitting the optical carrier signal (B) into individual branches,
- modulators ($M_i$) with which a respective branch of the central optical carrier signal (B) is modulated by one of the signals ($S_i$) to be measured,
- means for superimposing the modulated optical signals of the individual branches to form a composite signal (C), and
- an optical detector (PD) for measuring the composite signal (C),
- the optical path lengths from splitting to superimposing being different for each branch.

5. Apparatus according to claim 4, characterised in that the optical signals of the individual branches are carried in glass fibres ($F_i$, $F_i'$).

6. Apparatus according to claim 5, characterised in that the glass fibres ($F_i$, $F_i'$) are guided closely side by side predominantly along a common path.

7. Apparatus according to any one of claims 4 to 6, characterised in that. to achieve the different optical path lengths, each of the individual branches contains different length delay elements.

8. Apparatus according to claim 7, characterised in that the delay elements of the individual branches are arranged in a separate enclosed part of the apparatus.

9. Apparatus according to claim 8, characterised in that, to control the frequency of the optical carrier signal (B), an interferometer is present to generate a control signal, the delay elements of the individual interferometer branches being arranged in the separately enclosed part of the apparatus.

10. Apparatus according to any one of claims 4 to 9, characterised in that the means for splitting and superimposing (K1, K2) the optical carrier signal (B) and/or the modulators ($M_i$) are either optical transmission elements or optical reflection elements.

11. Apparatus according to any one of claims 4 to 10, characterised in that the optical signals of the individual branches are carried in an optical free-space structure.

12. Apparatus according to any one of claims 4 to 11, characterised in that the apparatus is of polarisation-maintaining construction.

13. Apparatus according to any one of claims 4 to 11, characterised in that the not all of the components of the apparatus are of polarisation-maintaining construction and remaining uncertainties in the polarisation states during superimposition of the individual branches are excluded by measuring the polarisation transfer characteristic by superimposition on receipt by means of at least two polarisation states that are independent of one another.

14. Apparatus according to any of claims 4 to 13, characterised in that, in the case of an electrical signal ($S_i$) to be measured, a modulator ($M_i$) is constructed as follows: an electro-optical element is arranged in the electric field close to a line which is carrying the electrical signal ($S_i$) to be measured.

15. Apparatus according to any one of claims 4 to 14, characterised in that modulators ($M_i$) are used, which, depending on the propagation direction of the signal being modulated relative to that of the optical signal to be modulated, are of different modulating efficiencies.

16. Apparatus according to any one of claims 4 to 15, characterised in that variable frequency lasers are used as light source (LQ).

17. Apparatus according to any one of claims 4 to 15, characterised in that stable frequency light sources (LQ) are used, a modulated light derived therefrom being used as optical carrier signal (B).

18. Apparatus according to any one of claims 4 to 17, characterised in that several light sources and/or optical detectors are used, so that several measurements can be carried out in parallel.

EP 0 586 889 B1

**19.** Application of the method according to any one of claims 1 to 3 in an apparatus according to any one of claims 4 to 18 for measuring the transit time of the optical carrier signal (B) in the individual branches.

**Revendications**

**1.** Procédé de mesure de l'amplitude et de la phase de plusieurs signaux à haute fréquence ($S_i$), caractérisé en ce que chaque signal à haute fréquence à mesurer ($S_i$) module une branche d'un signal porteur optique généré centralement (B) et les signaux optiques modulés des différentes branches sont ensuite superposés pour former un signal cumulé (C), la longueur de parcours optique adoptée pour chaque branche étant différente, pour plusieurs fréquences du signal porteur optique généré centralement le signal cumulé (C) étant mesuré du point de vue de l'amplitude et de la phase de la ligne principale et d'au moins une bande latérale par rapport au signal porteur généré centralement (B) et, à partir des valeurs d'amplitude et de phase correspondant à la ligne principale et à au moins une bande latérale à plusieurs fréquences du signal porteur optique généré centralement (B), des valeurs paramétriques représentant les valeurs des signaux à haute fréquence associés aux différentes branches étant calculées séparément les unes des autres pour les différentes branches, les valeurs paramétriques de la bande latérale d'une branche étant normées en fonction des paramètres de la ligne principale correspondante.

**2.** Procédé selon la revendication 1, caractérisé en ce qu'une branche supplémentaire décalée en fréquence du signal porteur optique (B) est superposée au signal cumulé (C).

**3.** Procédé selon la revendication 1 ou 2, caractérisé en ce que les signaux à haute fréquence sont de nature électrique.

**4.** Dispositif pour réaliser le procédé selon une des revendications précédentes, comprenant une source lumineuse (LQ) réglable en fréquence pour générer le signal porteur optique (B), des moyens pour diviser le signal porteur optique (B) en différentes branches, des modulateurs ($M_i$) avec lesquels chaque branche du signal porteur optique central (B) est modulée par l'un des signaux à mesurer ($S_i$), des moyens pour superposer les signaux optiques modulés des différentes branches et former un signal cumulé (C), et un détecteur optique (PD) pour mesurer le signal cumulé (C), les longueurs de parcours optique entre la division et la superposition étant différentes pour chaque branche.

**5.** Dispositif selon la revendication 4, caractérisé en ce que les signaux optiques des différentes branches sont acheminés dans des fibres optiques ($F_i$, $F_i'$).

**6.** Dispositif selon la revendication 5, caractérisé en ce que les fibres optiques ($F_i$, $F_i'$) sont très proches l'une de l'autres sur la majeure partie d'un parcours commun.

**7.** Dispositif selon l'une des revendications 4 à 6, caractérisé en ce que, pour réaliser les différentes longueurs de parcours optique, les différentes branches contiennent des éléments de temporisation de longueurs différentes.

**8.** Dispositif selon la revendication 7, caractérisé en ce que les éléments de temporisation des différentes branches sont disposés dans une partie encapsulée séparément.

**9.** Dispositif selon la revendication 8, caractérisé en ce que, pour régler la fréquence du signal porteur optique (B), il est prévu un interféromètre pour générer un signal de contrôle, les éléments de temporisation des différentes branches de l'interféromètre étant disposés dans la partie encapsulée séparément du dispositif.

**10.** Dispositif selon l'une des revendications 4 à 9, caractérisé en ce que les moyens pour diviser et superposer (K1, K2) le signal porteur optique (B) et/ou les modulateurs ($M_i$) sont soit des éléments de transmission optique soit des éléments de réflexion optique.

**11.** Dispositif selon l'une des revendications 4 à 10, caractérisé en ce que les signaux optiques des différentes branches sont acheminés dans une structure optique en espace libre.

**12.** Dispositif selon l'une des revendications 4 à 11, caractérisé en ce que le dispositif est conçu pour conserver la polarisation.

11

**13.** Dispositif selon l'une des revendications 4 à 11, caractérisé en ce que le dispositif n'est pas conçu pour conserver la polarisation dans toutes ses composantes, et les incertitudes subsistant sur le plan des états de polarisation lors de la superposition des différentes branches sont supprimées en mesurant le comportement de transmission de polarisation par superposition à la réception à l'aide d'au moins deux états de polarisation indépendants l'un de l'autre.

**14.** Dispositif selon l'une des revendications 4 à 13, caractérisé en ce qu'en présence d'un signal électrique à mesurer $(S_i)$ le modulateur $(M_i)$ est conçu comme suit : un élément électro-optique est disposé dans un champ électrique à proximité d'une ligne qui achemine le signal électrique à mesurer $(S_i)$.

**15.** Dispositif selon l'une des revendications 4 à 14, caractérisé en ce qu'il met en oeuvre des modulateurs $(M_i)$ qui, en fonction de la direction de propagation du signal modulé par rapport à celle du signal optique à moduler, ont une efficacité de modulation différente.

**16.** Dispositif selon l'une des revendications 4 à 15, caractérisé en ce que la source lumineuse (LQ) utilisée est constituée par des lasers à fréquence variable.

**17.** Dispositif selon l'une des revendications 4 à 15, caractérisé en ce que des sources lumineuses (LQ) à fréquence stable sont utilisées, la lumière modulée qui en est issue étant utilisée comme signal porteur optique (B).

**18.** Dispositif selon l'une des revendications 4 à 17, caractérisé en ce que plusieurs sources lumineuses et/ou détecteurs optiques sont utilisés, ce qui permet de procéder à plusieurs mesures parallèlement dans le temps.

**19.** Application du procédé selon l'une des revendications 1 à 3 dans un dispositif selon l'une des revendications 4 à 18 pour mesurer le temps de parcours du signal porteur optique (B) dans les différentes branches.

Fig. 1

EP 0 586 889 B1

# Fig. 2

$AE_1$    $AE_i$    $AE_n$

$M_1$    $M_i$    $M_n$

B

C

S

SVN

Fig.3

a)

SAE

LQ

PD

C

B

K1

$F_1$ $l_1$ $F_2$ $l_2$ $F_i$ $l_i$ $F_n$ $l_n$ $F_K$ $l_n$

$s_1^-$ $M_1$ $s_2^-$ $M_2$ $s_i^-$ $M_i$ $s_n^-$ $M_n$ FD

b)

OK

$s_i^-$ $M_i$ = $s_i^-$ $M_i$

EP 0 586 889 B1

15